# EUROPÄISCHE PATENTANMELDUNG

(11) **EP 1 953 871 A2**
(43) Veröffentlichungstag der Anmeldung: **06.08.2008**
(21) Anmeldenummer: 07120634.6
(22) Anmeldetag: 14.11.2007
(51) Int. Cl.: H01R 12/04, H01R 12/32, H01R 13/24, H01R 12/18

(54) **Anordnung eines ersten Schaltungsträgers auf einem zweiten Schaltungsträger**

(30) Priorität: 31.01.2007 AT 1512007
(71) Anmelder: Siemens AG Österreich, 1210 Wien (AT)
(72) Erfinder: Petricek, Martin, 2020 Hollabrunn (AT)
(74) Vertreter: Maier, Daniel Oliver

(57) **Zusammenfassung**

Die Erfindung betrifft eine Anordnung eines ersten Schaltungsträgers (1) auf einem zweiten Schaltungsträger (2), wobei der erste Schaltungsträger (1) zumindest einen Fortsatz (5) aufweist, welcher in eine durchkontaktierte Bohrung (4) des zweiten Schaltungsträgers (2) ragt, und wobei an dem Fortsatz (5) eine elektrisch leitende Kontaktfeder (3) in der Weise angeordnet ist, dass die Kontaktfeder (3) einerseits mit einem elektrischen Kontakt auf dem ersten Schaltungsträger (1) leitend verbunden ist und andererseits gegen die Bohrungsmantelfläche der Bohrung (4) des zweiten Schaltungsträgers (2) gedrückt ist.

## Beschreibung

Die Erfindung betrifft eine Anordnung eines ersten Schaltungsträgers auf einem zweiten Schaltungsträger, wobei der erste Schaltungsträger zumindest einen Fortsatz aufweist, welcher in eine durchkontaktierte Bohrung des zweiten Schaltungsträgers ragt.

Für ein kompaktes Layout von elektrischen Schaltungen ist es oftmals erforderlich, die Komponenten und Leiterbahnen der elektrischen Schaltung auf mehrere Schaltungsträger aufzuteilen. Dabei kennt man Anordnungen, bei welchen ein Schaltungsträger mit seinem Rand auf einer Oberfläche eines zweiten Schaltungsträger aufgesetzt ist. Komponenten und Leiterbahnen auf dem ersten Schaltungsträger sind dabei üblicherweise über elektrische Verbindungen im Kontaktbereich der beiden Schaltungsträger mit Komponenten und Leiterbahnen auf dem zweiten Schaltungsträger verbunden.

Nach dem Stand der Technik sind solche elektrischen Verbindungen beispielsweise in der Weise ausgestaltet, dass zapfenförmige Stifte am Rand des ersten Schaltungsträgers in durchkontaktierte Bohrungen des zweiten Schaltungsträgers ragen. Dabei sind die zapfenförmigen Stifte in der Regel mit verzinnten Oberflächen versehen, sodass sie in die Bohrungen des zweiten Schaltungsträgers eingelötet werden können. Dadurch ist eine nur mehr bedingt lösbare Verbindung gegeben, wodurch zum Beispiel bei Reparaturarbeiten aufwendige Lötarbeiten zum Trennen der elektrisch verbundenen Schaltungsträger notwendig sind.

Man kennt deshalb zur einfacheren Demontage lösbare, ineinander steckbare Stift- und Buchsenkontakte, wobei die Stifte auf dem ersten und die Buchsen auf dem zweiten Schaltungsträger aufgelötet sind. Die elektrische Verbindung der beiden Schaltungsträger erfolgt über diese Steckverbindungen. Derartige Verbindungslösungen sind jedoch aufwendig und teuer in der Herstellung, was deren Einsatzmöglichkeit beschränkt.

Der Erfindung liegt die Aufgabe zugrunde, für eine Anordnung eines ersten Schaltungsträgers auf einem zweiten Schaltungsträger eine Verbesserung gegenüber dem Stand der Technik anzugeben.

Erfindungsgemäß wird diese Aufgabe gelöst durch eine Anordnung der eingangs genannten Art, wobei an dem Fortsatz eine elektrisch leitende Kontaktfeder in der Weise angeordnet ist, dass die Kontaktfeder einerseits mit einem elektrischen Kontakt auf dem ersten Schaltungsträger leitend verbunden ist und andererseits gegen die Bohrungsmantelfläche der Bohrung des zweiten Schaltungsträgers gedrückt ist.

Eine derartige Kontaktfeder ist günstig in der Herstellung und erlaubt ein einfaches Anbringen auf einem Fortsatz des ersten Schaltungsträgers. Der elektrische Kontakt auf dem ersten Schaltungsträger ist zum Beispiel das Ende einer Leiterbahn oder ein Pin eines elektronischen Bauteils. Im montierten Zustand der beiden Schaltungsträger übt die Feder eine Anpresskraft gegen die Mantelfläche einer durchkontaktierten Bohrung des zweiten Schaltungsträgers aus, wobei diese Mantelfläche den elektrischen Gegenkontakt bildet. Auf diese Weise ist eine einfache leitende Verbindung des elektrischen Kontakts auf dem ersten Schaltungsträger mit dem elektrischen Gegenkontakt auf dem zweiten Schaltungsträger gegeben. Eine derartige elektrisch leitende Verbindung ist einerseits sehr beständig und andererseits jederzeit ohne Aufwand demontierbar.

In einer vorteilhaften Ausprägung der Erfindung ist die Kontaktfeder in der Weise an dem Fortsatz angeordnet, dass der gemeinsame Querschnitt der nicht zusammengedrückten Kontaktfeder und des Fortsatzes am Ende des Fortsatzes innerhalb des Bohrungsquerschnittes der Bohrung liegt, und dass der gemeinsame Querschnitt der nicht zusammengedrückten Kontaktfeder und des Fortsatzes in einem Bereich, der im montierten Zustand in die Bohrung ragt, über den Bohrungsquerschnitt der Bohrung hinausragt. Die Kontaktfeder bildet dabei gemeinsam mit dem Fortsatz einen Keil, der in einfacher Weise in die Bohrung hineinschiebbar ist, ohne dass die Kontaktfeder davor zusammengedrückt werden muss.

Dabei ist es günstig, wenn die Kontaktfeder als gebogene Blattfeder ausgebildet ist. Die Kontaktfeder besteht dann z.B. aus einem gebogenen Blechstreifen, dessen Längsausrichtung im Wesentlichen parallel zur Montagerichtung verläuft. Dabei weist der Blechstreifen eine Wölbung in Richtung der Bohrungsmantelfläche des zweiten Schaltungsträgers auf, wobei diese Wölbung im montierten Zustand flachgedrückt ist.

Des Weiteren ist es von Vorteil, wenn der elektrische Kontakt auf dem ersten Schaltungsträger als durchkontaktierte Bohrung im Bereich des Fortsatzes ausgebildet ist und wenn ein erstes Ende der Kontaktfeder durch diese Bohrung geführt ist. Damit ist einerseits die Kontaktfeder am Fortsatz in Position gehalten und andererseits ist auf einfache Weise eine Lötverbindung mit dem elektrischen Kontakt herstellbar.

Bei einer derartigen Anordnung ist es zudem günstig, wenn die Kontaktfeder im Bereich des ersten Endes, das durch die Bohrung des ersten Schaltungsträgers geführt ist, einen geringeren Querschnitt als im übrigen Bereich der Kontaktfeder aufweist. Das erleichtert die Montage, weil das durch die Bohrung zu führende Ende klar definiert ist. Zudem sind an der Kontaktfeder durch die Querschnittsverengung Schultern ausgebildet, die am Bohrungsrand aufliegen und so die Kontaktfeder in Position halten.

Dabei ist es des Weiteren günstig, die Kontaktfeder derart auszubilden, dass das durch die Bohrung des ersten Schaltungsträgers geführte erste Ende der Kontaktfeder aus der Bohrung herausragt und in der Weise abgewinkelt ist, dass es am Rand der Bohrung eingeschnappt ist. Bei der Montage wird das abgewinkelte Ende der Kontaktfeder in die Bohrung geführt und gleitet federnd an der Bohrungsmantelfläche, bis es an der gegenüberliegenden Bohrungsöffnung herausragt und zurückfedernd den Bohrungsrand umfasst. Die Kontaktfeder ist somit in der Bohrung fixiert.

Um eine dauerhafte Fixierung der Kontaktfeder in der Bohrung sicherzustellen ist es von Vorteil, wenn die Kontaktfeder mit dem elektrischen Kontakt auf dem ersten Schaltungsträger verlötet ist.

In einer weiteren vorteilhaften Ausprägung der Erfindung ist es von Vorteil, auf dem ersten Schaltungsträger eine weitere Bohrung anzuordnen, durch die ein zweites Ende der Kontaktfeder geführt ist. Damit wird eine zusätzliche Fixierung der Kontaktfeder erreicht.

Günstig ist bei dieser Ausprägung, wenn die Achsen der durchkontaktierten Bohrung und der weiteren Bohrung des ersten Schaltungsträgers sowie der Bohrung des zweiten Schaltungsträgers in einer Ebene liegen.

Für die elektrische Leitfähigkeit der Kontaktfeder ist es günstig, wenn diese aus Kupfer oder Messing mit einer lötfähigen Oberfläche besteht.

Die Erfindung wird nachfolgend in beispielhafter Weise unter Bezugnahme auf die beigefügten Figuren erläutert. Es zeigen in schematischer Darstellung:
- Fig. 1: Anordnung von zwei Schaltungsträgern mit Kontaktfedern im demontierten Zustand
- Fig. 2: Fortsatz mit Kontaktfeder des ersten Schaltungsträgers, welcher in eine Bohrung des zweiten Schaltungsträgers ragt
- Fig. 3: Anordnung von zwei Schaltungsträgern mit Kontaktfedern im montierten Zustand

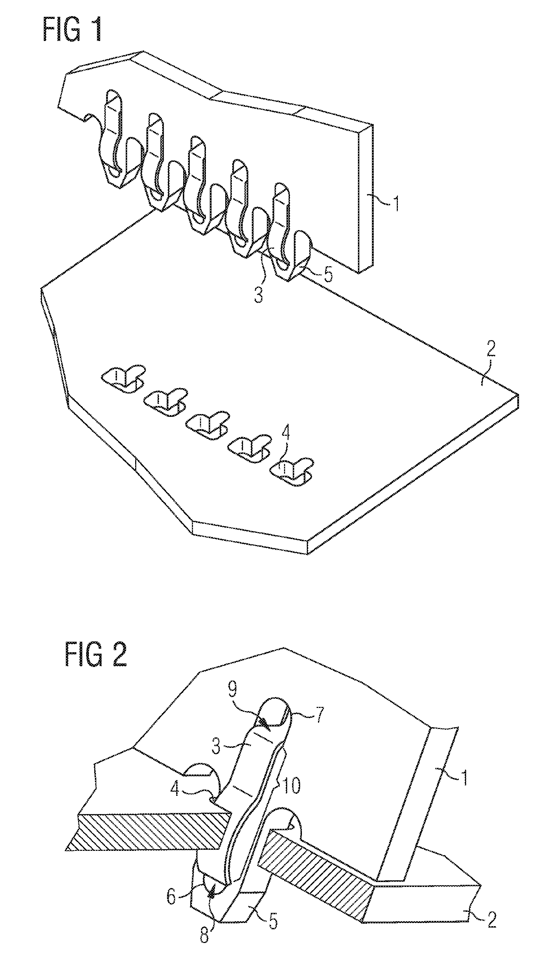

In Fig. 1 ist der erste Schaltungsträger 1 mit fünf am Rand ausgebildeten Fortsätzen 5 dargestellt. An jedem Fortsatz 5 ist eine Kontaktfeder 3 angeordnet. Mit dieser beispielhaften Anordnung sind demnach fünf elektrische Verbindungen zwischen Kontakten auf dem ersten Schaltungsträger 1 und Gegenkontakten auf dem zweiten Schaltungsträger 2 realisierbar. Dabei ist zum Beispiel jede Kontaktfeder 3 elektrisch leitend mit nicht dargestellten Enden von Leiterbahnen auf dem ersten Schaltungsträger verlötet.

Im zweiten Schaltungsträger 2 sind die Gegenkontakte als Bohrungen 4 ausgebildet. Beim Aufsetzen des ersten Schaltungsträgers 1 auf den zweiten Schaltungsträger 2 ragt jeder Fortsatz 5 in eine Bohrung 4, wodurch elektrische Verbindungen zwischen den Kontaktfedern 3 und den durchkontaktierten Bohrungen 4 entstehen. Dabei ist jede Bohrungsmantelfläche der Bohrungen 4 beispielsweise mit einer nicht dargestellten Leiterbahn oder einem Pin eines elektronischen Bauelements auf dem zweiten Schaltungsträger 2 kontaktiert.

Figur 2 zeigt im Detail einen Fortsatz 5 mit Kontaktfeder 3 im Kontakt mit einer Bohrung 4, wobei zum besseren Verständnis der zweite Schaltungsträger 2 geschnitten dargestellt ist. Der erste Schaltungsträger 1 liegt mit dem Rand, an dem sich der Fortsatz 5 befindet, auf der zur Anordnung von Schaltungselementen vorgesehenen Oberfläche des zweiten Schaltungsträgers 2 auf. Der Fortsatz 5 ist dabei so ausgebildet, dass er im Wesentlichen zapfenförmig mit rechteckigem Querschnitt über den Rand des ersten Schaltungsträgers 1 hinausragt und somit durch die Bohrung 4 im zweiten Schaltungsträger 2 hindurchragt. Der Übergang zwischen Fortsatz 5 und aufliegendem Rand des ersten Schaltungsträgers 1 ist mit halbrunden Ausnehmungen hinterschnitten, damit der Randes auf dem zweiten Schaltungsträger 2 plan aufliegen kann. Am Ende des Fortsatzes 5 sind Fasen angebracht, die beim Montieren das Einschieben des Fortsatzes 5 in die Bohrung 4 erleichtern. Auf einer Seite des Fortsatzes 5, welche in die zur Anordnung von Schaltungselementen vorgesehene Oberfläche des ersten Schaltungsträgers 1 übergeht, ist der federnde Abschnitt 10 der Kontaktfeder 3 angeordnet.

Die beispielhaft dargestellte streifenförmig gebogene Kontaktfeder 3 ist im Wesentlichen in drei Abschnitte 8, 9, 10 gegliedert. Diese drei Abschnitte sind ein erstes abgewinkeltes Ende 8, ein zweites abgewinkeltes Ende 9 und der mittlere federnde Abschnitt 10. Das erste abgewinkelte Ende 8 der Kontaktfeder 3 ist durch eine erste Bohrung 6 im Fortsatze 5 geführt und an der nicht sichtbaren Rückseite des Fortsatzes 5 am Rand der ersten Bohrung 6 mit einer Abwinkelung eingeschnappt. Am Übergang des ersten abgewinkelten Endes 8 zum federnden Abschnitt 10 verbreitert sich der Querschnitt der Kontaktfeder 3. Die auf diese Weise gebildeten Schultern der Kontaktfeder 3 liegen am Rand der Bohrung 6 auf.

Das zweite abgewinkelte Ende 9 der Kontaktfeder 3 ragt durch eine zweite Bohrung 7 in der ersten Schaltungsplatte 1. Die Achse dieser zweiten Bohrung 7 liegt mit der Achse der ersten Bohrung 6 und der Achse der Bohrung 4 im zweiten Schaltungsträgers 2 in einer Ebene. Das zweite Ende 9 der Kontaktfeder 3 ist mit einer Abwinkelung versehen, welche den Bohrungsrand der zweiten Bohrung 7 an der nicht sichtbaren Rückseite des ersten Schaltungsträgers 1 umfasst.

Eine derart gestaltete Kontaktfeder 3 ist am Fortsatz 5 sicher fixiert. Die Verbindung mit einem elektrischen Kontakt auf dem ersten Schaltungsträger 1 erfolgt beispielsweise durch Einlöten eines der Kontaktfederenden 8, 9 mit einer der beiden Bohrungen 6, 7, welche zu diesem Zweck durchkontaktiert ausgeführt ist.

Den Gegenkontakt auf dem zweiten Schaltungsträger 2 bildet die ebenfalls durchkontaktierte Bohrung 4, durch die der Fortsatz 5 mit der Kontaktfeder 3 ragt. Der Bohrungsquerschnitt ist dabei dem gemeinsamen Querschnitt des Fortsatzes 5 und der Kontaktfeder 3 angepasst. In der dargestellten beispielhaften Ausführung ist die Bohrung 4 im zweiten Schaltungsträger 2 demnach im Wesentlichen rechteckig mit einer Nut zum Freistellen der Abwinkelung des ersten Endes 8 der Kontaktfeder 3.

Die Abmaße der Bohrung 4 im zweiten Schaltungsträger 2 sind dabei so zu wählen, dass der Fortsatz 5 mit der Kontaktfeder 3 einerseits leicht aufgenommen werden kann und andererseits der federnde Abschnitt 10 der Kontaktfeder 3 im montierten Zustand gegen die Mantelfläche der Bohrung 4 gedrückt ist. Der federnde Abschnitt 10 der Kontaktfeder 3 ist dabei in der Weise gewölbt ausgeführt, dass das Ende des Fortsatzes 5 mit der Kontaktfeder 3 zunächst reibungsfrei in die Bohrung 4 eingesetzt werden kann. Beim weiteren Einschieben des Fortsatzes 5 mit der Kontaktfeder 3 beginnt die Wölbung der Kontaktfeder 3 an der Mantelfläche der Bohrung 4 zu gleiten, wodurch die Wölbung flachgedrückt wird und eine Anpresskraft der Kantaktfeder 3 gegen die Mantelfläche der Bohrung 4 entsteht. Auf diese Weise ist eine dauerhaftere elektrische Verbindung zwischen der Kontaktfeder 3 als Kontakt des ersten Schaltungsträgers 1 und der z.B. verzinnten Mantelfläche der Bohrung 4 als Gegenkontakt des zweiten Schaltungsträgers 2 sichergestellt.

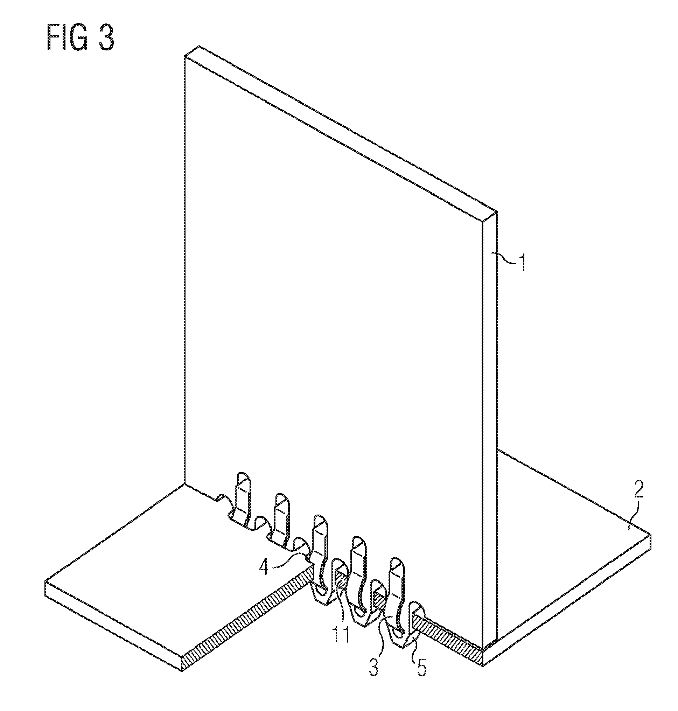

Figur 3 zeigt die Anordnung eines ersten Schaltungsträgers 1 auf einem zweiten Schaltungsträger 2 im montieren Zustand, wobei der zweite Schaltungsträger 2 wieder geschnitten dargestellt ist. Es sind fünf Fortsätze 5 mit Kontaktfedern 3 angeordnet, die in fünf durchkontaktierte Bohrungen 4 im zweiten Schaltungsträger 2 ragen. Dabei ist darauf zu achten, dass die Querschnitte der sich ergebenen Stege 11 zwischen den Bohrungen 4 ausreichend breit sind, damit eine ausreichende mechanische Stabilität des zweiten Schaltungsträgers 2 gegeben ist.

Die vorliegende Erfindung ist nicht auf die dargestellten Ausgestaltungen der Fortsätze, Kontaktfedern und Bohrungen beschränkt. Die Kontaktfeder kann beispielsweise auch als Schraubenfeder ausgebildet sein, welche in eine Sackbohrung oder in eine durchgängige Bohrung im Fortsatz des ersten Schaltungsträgers eingelötet ist.

Des Weiteren ist eine Ausprägung möglich, bei welcher im ersten Schaltungsträger keine Bohrungen vorgesehen sind. Eine als Blattfeder oder Schraubenfeder ausgebildete Kontaktfeder wird dabei auf eine leitende Kontaktfläche am Fortsatz des Schaltungsträgers aufgelötet oder aufgeklebt.

Die Erfindung ist auch mit einer zusammengesetzten Kontaktfeder ausführbar, welche aus einem Kontaktstreifen und einer Schraubenfeder besteht. Dabei ist der Kontaktstreifen mit einem elektrischen Kontakt auf dem ersten Schaltungsträger leitend verbunden und wird mit der zwischen Kontaktstreifen und Fortsatz angeordneten Schraubenfeder gegen die Mantelfläche der Bohrung im zweiten Schaltungsträger gedrückt.

## Patentansprüche

1. Anordnung eines ersten Schaltungsträgers (1) auf einem zweiten Schaltungsträger (2), wobei der erste Schaltungsträger (1) zumindest einen Fortsatz (5) aufweist, welcher in eine durchkontaktierte Bohrung (4) des zweiten Schaltungsträgers (2) ragt, **dadurch gekennzeichnet, dass** an dem Fortsatz (5) eine elektrisch leitende Kontaktfeder (3) in der Weise angeordnet ist, dass die Kontaktfeder (3) einerseits mit einem elektrischen Kontakt auf dem ersten Schaltungsträger (1) leitend verbunden ist und andererseits gegen die Bohrungsmantelfläche der Bohrung (4) des zweiten Schaltungsträgers (2) gedrückt ist.

2. Anordnung nach Anspruch 1, **dadurch gekennzeichnet, dass** die Kontaktfeder (3) in der Weise an dem Fortsatz (5) angeordnet ist, dass der gemeinsame Querschnitt der nicht zusammengedrückten Kontaktfeder (3) und des Fortsatzes (5) am Ende des Fortsatzes (5) innerhalb des Bohrungsquerschnittes der Bohrung (4) liegt, und dass der gemeinsame Querschnitt der nicht zusammengedrückten Kontaktfeder (3) und des Fortsatzes (5) in einem Bereich, der im montierten Zustand in die Bohrung (4) ragt, über den Bohrungsquerschnitt der Bohrung (4) hinausragt.

3. Anordnung nach Anspruch 1 oder 2, **dadurch gekennzeichnet, dass** die Kontaktfeder (3) als gebogene Blattfeder ausgebildet ist.

4. Anordnung nach einem der Ansprüche 1 bis 3, **dadurch gekennzeichnet, dass** der elektrische Kontakt auf dem ersten Schaltungsträger (1) als durchkontaktierte Bohrung (6) im Bereich des Fortsatzes (5) ausgebildet ist und dass ein erstes Ende (8) der Kontaktfeder (3) durch diese Bohrung (6) geführt ist.

5. Anordnung nach Anspruch 4, **dadurch gekennzeichnet, dass** die Kontaktfeder (3) im Bereich des ersten Endes (8), das durch die Bohrung (6) des ersten Schaltungsträgers (1) geführt ist, einen geringeren Querschnitt als im übrigen Bereich der Kontaktfeder (3) aufweist.

6. Anordnung nach Anspruch 4 oder 5, **dadurch gekennzeichnet, dass** das durch die Bohrung (6) des ersten Schaltungsträgers (1) geführte erste Ende (8) der Kontaktfeder (3) aus der Bohrung (6) herausragt und in der Weise abgewinkelt ist, dass es am Rand der Bohrung (6) eingeschnappt ist.

7. Anordnung nach einem der Ansprüche 1 bis 6, **dadurch gekennzeichnet, dass** die Kontaktfeder (3) mit dem elektrischen Kontakt auf dem ersten Schaltungsträger (1) verlötet ist.

8. Anordnung nach einem der Ansprüche 4 bis 7, **dadurch gekennzeichnet, dass** auf dem ersten Schaltungsträger (1) eine weitere Bohrung (7) angeordnet ist, durch die ein zweites Ende (9) der Kontaktfeder (3) geführt ist.

9. Anordnung nach Anspruch 8, **dadurch gekennzeichnet, dass** die Achsen der durchkontaktierten Bohrung (6) und der weiteren Bohrung (7) des ersten Schaltungsträgers (1) sowie der Bohrung (4) des zweiten Schaltungsträgers (2) in einer Ebene liegen.

10. Anordnung nach einem der Ansprüche 1 bis 9, **dadurch gekennzeichnet, dass** die Kontaktfeder (3) aus Kupfer oder Messing mit einer lötfähigen Oberfläche besteht.
